Europäisches Patentamt

European Patent Office

Office européen des brevets

(19)

(11) **EP 0 851 553 B1**

(12) **FASCICULE DE BREVET EUROPEEN**

(45) Date de publication et mention
de la délivrance du brevet:
**07.07.2004  Bulletin 2004/28**

(51) Int Cl.⁷: **H02H 3/093**

(21) Numéro de dépôt: **97410136.2**

(22) Date de dépôt: **01.12.1997**

(54) **Déclencheur électronique comportant, en série, des filtres à réponse impulsionnelle finie et infinie**

Elektronischer Auslöser mit, in Reihe geschalten, einem nichtrekursivem und einem rekursivem Filter

Electronic trip device comprising, in series, a finite and infinite impulse response filter

(84) Etats contractants désignés:
**DE ES GB IT**

(30) Priorité: **23.12.1996  FR 9616152**

(43) Date de publication de la demande:
**01.07.1998  Bulletin 1998/27**

(73) Titulaire: **Schneider Electric Industries SAS**
**92500 Rueil-Malmaison (FR)**

(72) Inventeurs:
• **Nguyen, Hong**
**38050 Grenoble cedex 09 (FR)**
• **Del Vecchio, Alain**
**38050 Grenoble cedex 09 (FR)**

(74) Mandataire: **Jouvray, Marie-Andrée et al**
**Schneider Electric SA,**
**Sce. Propriété Industrielle, - A7**
**38050 Grenoble Cedex 09 (FR)**

(56) Documents cités:
**EP-A- 0 603 088          WO-A-92/04635**

• **MARTINEZ H G ET AL: "Hybrid implementations of narrow band digital filters" PROCEEDINGS OF THE 1979 INTERNATIONAL SYMPOSIUM ON CIRCUITS AND SYSTEMS, TOKYO, JAPAN, 17-19 JULY 1979, 1979, NEW YORK, NY, USA, IEEE, USA, pages 364-365, XP002039262**
• **PATENT ABSTRACTS OF JAPAN vol. 016, no. 120 (E-1182), 26 mars 1992 & JP 03 289270 A (NIPPON PHILIPS KK), 19 décembre 1991,**

## Description

L'invention concerne un déclencheur électronique connecté à des moyens de mesure du courant circulant dans un réseau électrique polyphasé à protéger et comportant des moyens d'échantillonnage de signaux de courant fournis par les moyens de mesure, des moyens de calcul, connectés aux moyens d'échantillonnage et calculant une grandeur représentative de l'état thermique du réseau, et des moyens de comparaison de ladite grandeur à des seuils de déclenchement prédéterminés, les moyens de calcul comportant des premiers moyens de filtrage, du type filtre à réponse impulsionnelle finie, recevant les échantillons de signaux de courant et fournissant des signaux représentatifs de la valeur efficace du courant.

Dans certains déclencheurs électroniques connus, à microprocesseur, certaines fonctions de déclenchement, notamment long retard, sont réalisées au moyen d'un filtre numérique à réponse impulsionnelle finie (FIR). Un tel filtre permet de faire la somme d'un nombre prédéterminé d'échantillons. Si les échantillons d'entrée du filtre sont constitués par les carrés des échantillons représentatifs du courant mesuré, on obtient en sortie des signaux représentatifs de la valeur efficace du courant mesuré. Ce type de filtre ne permet cependant pas toujours d'obtenir la réponse en fréquence désirée dans la mesure où les harmoniques ne sont pas suffisamment atténués et ne permet pas d'avoir une représentation de l'état thermique de l'installation.

Dans d'autres déclencheurs électroniques connus, on utilise un filtre numérique à réponse impulsionnelle infinie (IIR) afin de modéliser l'état thermique de l'installation. Si la fréquence d'échantillonnage est suffisamment élevée, les résultats obtenus sont satisfaisants. A titre d'exemple, un filtre de ce type s'avère satisfaisant pour une fréquence d'échantillonnage de 1600 Hz pour les réseaux classiques à 50 Hz, 60 Hz ou 400 Hz. Par contre, si l'on désire utiliser un microprocesseur bon marché, ce qui impose de limiter la fréquence d'échantillonnage, les résultats obtenus ne sont pas satisfaisants en ce qui concerne la précision de la mesure.

L'invention a pour but un déclencheur bon marché permettant d'obtenir des résultats satisfaisants à la fois pour le filtrage et la modélisation de l'état thermique.

Selon l'invention, ce but est atteint par un déclencheur selon la revendication 1.

D'autres avantages ressortiront plus clairement de la description qui va suivre de modes de réalisation particuliers de l'invention, donnés à titre d'exemples non limitatifs et représentés aux dessins annexés dans lesquels :

- la figure 1 illustre, sous forme de schéma bloc, un déclencheur de type connu,

- les figures 2 et 3 représentent, schématiquement, des modes de réalisation particuliers du circuit de traitement du déclencheur selon la figure 1, respectivement avec un filtre à réponse impulsionnelle infinie (fig. 2) et avec un filtre à réponse impulsionnelle finie (fig. 3).

- les figures 4 et 5 illustrent respectivement les réponses en fréquence des fonctions de transfert K1 et K2 des filtres selon les figures 2 et 3, respectivement pour des fréquences d'échantillonnage de 1600 Hz et de 800 Hz.

- la figure 6 représente la réponse en fréquence de la fonction de transfert K3 d'un filtre selon la figure 2 pour une fréquence d'échantillonnage de 800 Hz.

- la figure 7 illustre un mode de réalisation particulier du circuit de traitement correspondant à une phase d'un déclencheur selon l'invention.

- la figure 8 illustre la succession d'échantillons appliqués à l'entrée du filtre à réponse impulsionnelle finie(FIR) du circuit selon la figure 7.

- la figure 9 illustre, plus en détail, un mode de réalisation particulier du filtre à réponse impulsionnelle infinie du circuit selon la figure 7.

- la figure 10 représente la réponse en fréquence des fonctions de transfert K'1, K'2 et K4 respectivement du filtre à réponse impulsionnelle infinie, du filtre à réponse impulsionnelle finie, et de l'ensemble des deux filtres du circuit selon la figure 7, pour une fréquence d'échantillonnage de 900 Hz.

- la figure 11 représente un mode particulier de réalisation de l'invention dans le cas d'un réseau polyphasé.

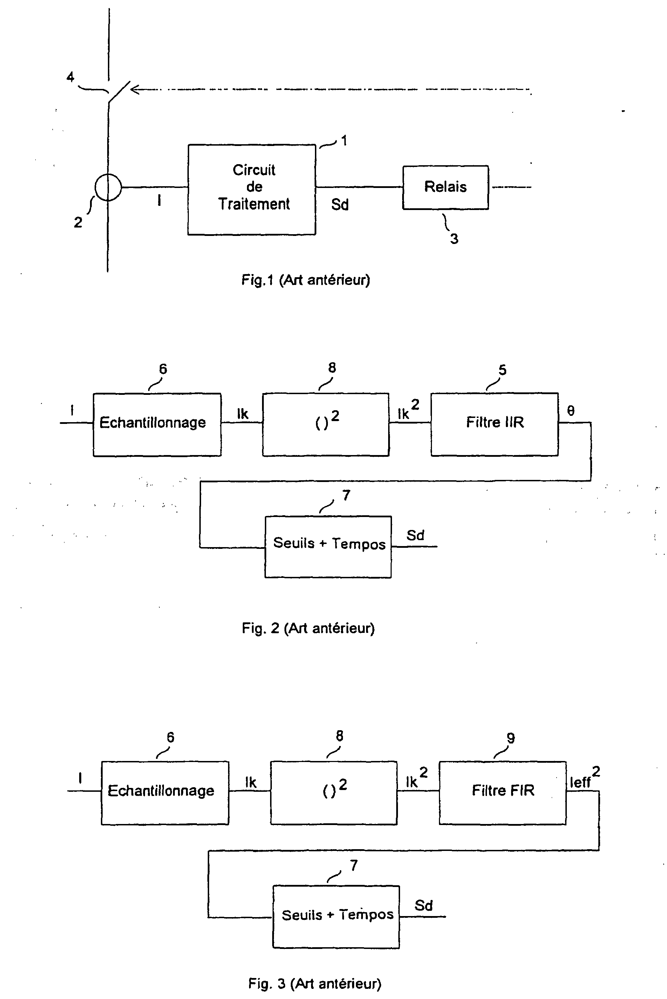

Sur la figure 1, le déclencheur comporte un circuit de traitement 1, à microprocesseur, recevant en entrée des signaux représentatifs du courant I circulant dans un réseau électrique à protéger. Pour simplifier les explications, sur la figure 1, le réseau électrique est représenté schématiquement sous la forme d'un réseau monophasé et un capteur de courant 2 fournit au déclencheur les signaux I. En cas de défaut dans le réseau, le circuit de traitement 1 fournit, éventuellement après une temporisation appropriée, des signaux Sd de déclenchement à un relais 3 qui provoque l'ouverture d'un disjoncteur 4 et l'interruption de la circulation du courant dans le réseau.

Le mode de réalisation particulier du circuit de traitement selon l'art antérieur illustré à la figure 2 comporte un filtre numérique 5 à réponse impulsionnelle infinie, ou filtre IIR. Les signaux de courant I sont appliqués à l'entrée d'un circuit d'échantillonnage 6 qui fournit en sortie des échantillons de courant Ik. L'entrée du filtre IIR est connectée à la sortie du circuit d'échantillonnage 6 par l'intermédiaire d'un circuit 8 d'élévation au carré. Les signaux θ de sortie du filtre IIR sont représentatifs de l'état thermique du réseau et sont appliqués à l'entrée d'un circuit 7 de comparaison à des seuils de déclenchement. Le circuit 7 comporte éventuellement des temporisations et fournit un signal de déclenchement Sd si la grandeur θ est supérieure à un seuil prédéterminé pendant la durée de la temporisation correspondante.

Dans le mode de réalisation du circuit de traitement de la figure 3, la sortie du circuit d'échantillonnage 6 est connectée à l'entrée d'un circuit 8 d'élévation au carré, dont la sortie est connectée à l'entrée d'un filtre numérique 9 à réponse impulsionnelle finie, ou filtre FIR. Les signaux de sortie du filtre FIR 9 sont représentatifs du carré Ieff$^2$ de la valeur efficace du courant circulant dans le réseau. Le circuit de comparaison 7 fournit un signal de déclenchement si le carré de la valeur efficace du courant est supérieur à un seuil prédéterminé pendant la durée de la temporisation correspondante.

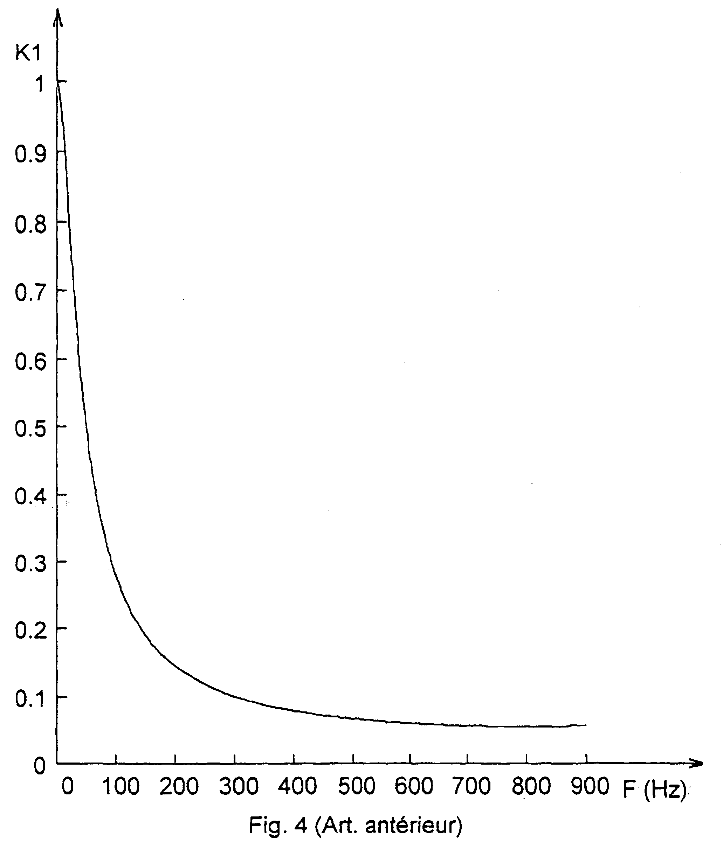

La réponse en fréquence de la fonction de transfert K1 du filtre IIR 5 de la figure 2 est illustrée à la figure 4 pour une fréquence d'échantillonnage de 1600 Hz. La fonction de transfert K1 est de la forme :

$$K1 = \left| \alpha 1 / \left[ 1 + (\alpha 1 - 1) e^{-j2\pi F.Te} \right] \right|$$

où F est la fréquence, $\alpha 1$ une constante telle que : $\alpha 1 = Te/\tau$, $\tau$ étant la constante de temps de filtre 5 et Te la période d'échantillonnage.

Le filtre IIR 5 refait le calcul d'une nouvelle valeur θk de θ à chaque échantillon Ik à partir de la valeur de θk -1 précédemment calculée et du nouvel échantillon Ik.

La réponse en fréquence K1 est acceptable car elle atténue correctement aussi bien les harmoniques de 50 Hz, que ceux de 60 Hz et ceux de 400 Hz.

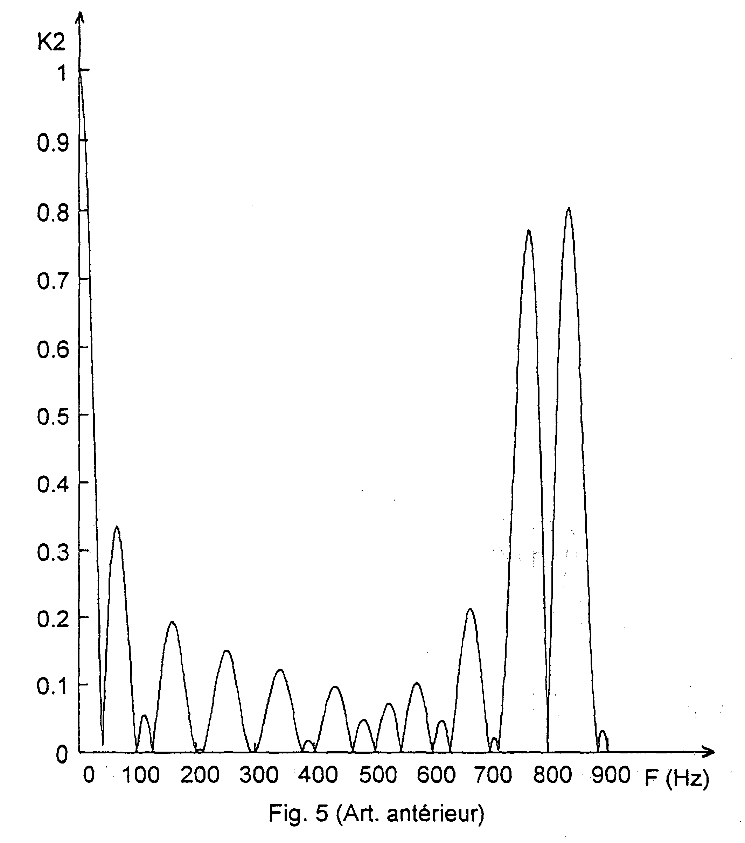

La figure 5 représente la réponse en fréquence de la fonction de transfert K2 du filtre FIR 9 de la figure 3, pour une fréquence d'échantillonnage de 800 Hz et un calcul de valeur efficace utilisant 16 échantillons. De plus, de manière connue, une période de décalage td, de quelques millisecondes, 1,9ms dans le mode de réalisation représenté, est ajoutée à la période d'échantillonnage Te après chaque groupe de 8 échantillons. Un tel décalage permet de filtrer efficacement à la fois les harmoniques du 50 Hz et ceux du 60 Hz. La fonction de transfert K2 est de la forme :

$$K2 = \left| \sum_{k=0}^{7} e^{-j2\pi FkTe} + \sum_{k=0}^{7} e^{-j2\pi F(Te(k+8)+td)} \right| / 16$$

L'atténuation des harmoniques peut être considérée comme satisfaisante avec la fréquence d'échantillonnage choisie, 800 Hz, inférieure à la fréquence d'échantillonnage associée à K1. Cependant, le circuit selon la figure 3 ne permet pas de tenir compte de l'échauffement réel des conducteurs du réseau. On obtient d'ailleurs des résultats différents, selon que l'on utilise le circuit selon la figure 2 ou selon la figure 3.

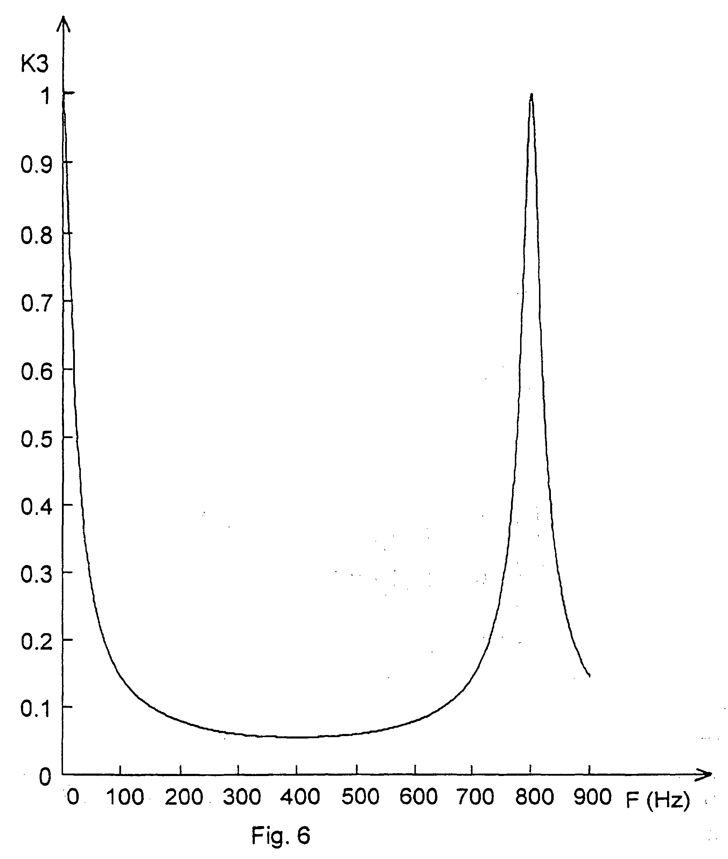

Par ailleurs, si l'on diminue la fréquence d'échantillonnage dans un circuit à filtre IIR selon la figure 2, la réponse en fréquence devient insatisfaisante. Une telle réponse est, par exemple, illustrée à la figure 6, avec une fréquence d'échantillonnage de 800 Hz. Il est clair que les harmoniques du 400 Hz, notamment, ne sont pas du tout atténués.

Selon l'invention, il est possible d'obtenir une réponse en fréquence tout à fait satisfaisante avec une fréquence d'échantillonnage très inférieure à celle (1600 Hz) utilisée jusqu'ici avec un filtre de type IIR, par exemple avec une fréquence d'échantillonnage de l'ordre de 900 Hz.

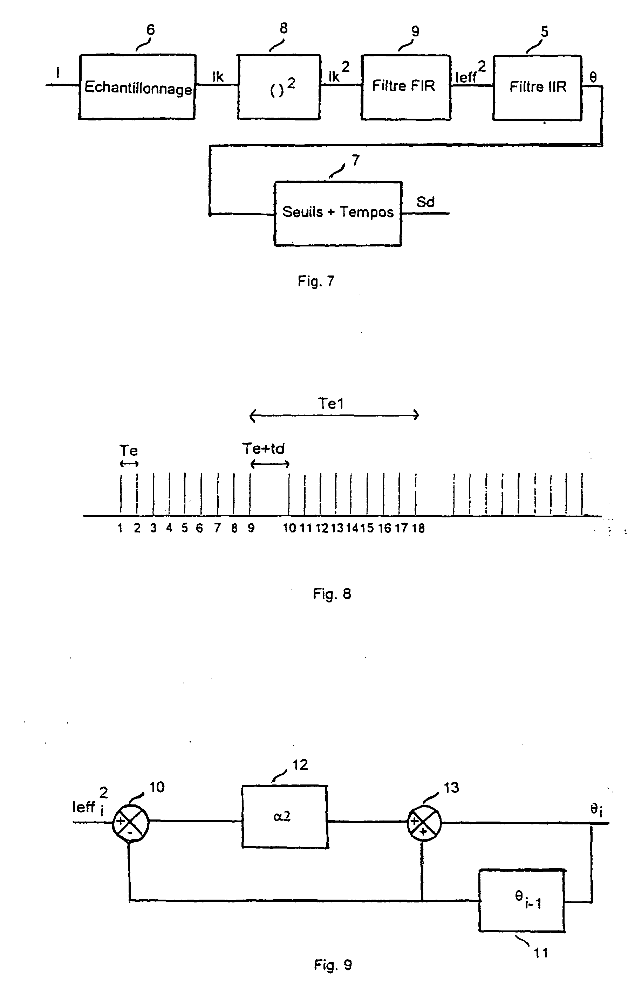

Le circuit de traitement selon la figure 7, comporte un filtre FIR 9 et un filtre IIR 5 en série entre le circuit 8 d'élévation au carré et le circuit de comparaison 7.

Comme représenté à la figure 8, l'échantillonneur 6 fournit des échantillons Ik, k = 1 à 9 avec une période Te correspondant à une fréquence d'échantillonnage Fe de 900 Hz. Puis, une période de décalage td = 2,4 ms est ajoutée à la période d'échantillonnage et un nouveau groupe de 9 échantillons Ik, k = 10 à 18 est produit avant un nouveau décalage.

La fonction de transfert K'2 du filtre 9 est de la forme :

$$K'2 = \left| \sum_{k=1}^{9} e^{-j2\pi F.kTe} + \sum_{k=1}^{9} e^{-j2\pi F(Te(k+9)+td)} \right| / 18$$

avec Te = 1/Fe = 1/900

td = 2,4 ms

Le filtre FIR 9 calcule une nouvelle valeur $Ieff^2i$ du carré $Ieff^2$ de la valeur efficace du courant après chaque groupe de 9 échantillons successifs, en utilisant les 18 derniers échantillons, c'est à dire un nombre d'échantillons double de celui compris entre deux décalages successifs. La période Te1 de calcul de $Ieff^2$ est donnée par :

Te1 =9Te+td = 12, 4 ms

Cette période Te1 correspond à une fréquence d'échantillonnage Fe 1 < < Fe à l'entrée du filtre IIR 5. Celui-ci calcule une nouvelle valeur θi de θ à chaque nouveau calcul de $Ieff^2$, c'est à dire avec la fréquence Fe1, voisine de 80 Hz.

La fonction de transfert K'1 du filtre IIR 5 de la figure 7 est de la forme :

$$K'1 = \left| \alpha2 / \left[ 1 + (\alpha2 - 1)e^{-j2\pi F.Te1} \right] \right|$$

Une telle fonction de transfert peut être réalisée, comme illustré à la figure 9. La valeur $Ieff^2i$ est appliquée à une entrée "+" d'un opérateur 10 qui reçoit sur une entrée "-" la valeur θi-1 précédemment calculée et mise en mémoire dans un circuit 11. La différence $Ieff^2i$ - θi-1 est appliquée à l'entrée d'un opérateur 12 qui la multiplie par la constante $\alpha2$. Le produit $\alpha2$ ($Ieff^2i$ - θi-1) est appliqué à une entrée "+" d'un opérateur 13 qui reçoit sur une autre entrée "+" la valeur θi-1. La sortie θi de l'opérateur 13 est alors de la forme :

$$\theta i = \theta i-1 + \alpha2 (Ieff^2i - \theta i-1)$$

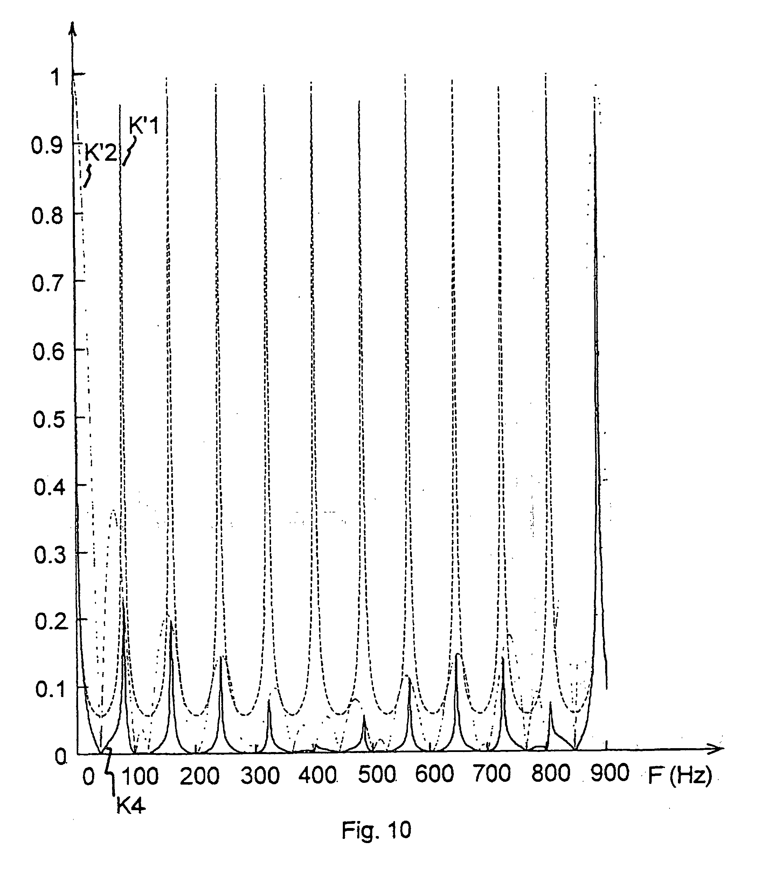

Les réponses en fréquence K' 1 du filtre IIR 5, K'2 du filtre FIR 9, et K4 de l'ensemble des deux filtres en série de la figure 7 sont illustrées à la figure 10.

Il ressort clairement de la figure 10 que la réponse en fréquence de la fonction de transfert K4 atténue de manière satisfaisante à la fois les harmoniques du 50 Hz, du 60 Hz et du 400 Hz.

L'échantillonnage et le calcul doivent se faire à intervalles de temps précis. Pour cela, ces fonctions sont réalisées par le microprocesseur du circuit de traitement sous interruption.

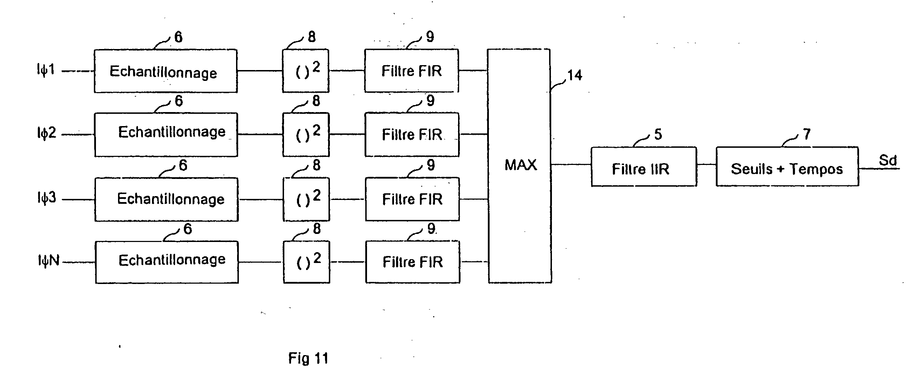

Le réseau étant polyphasé, par exemple triphasé, avec ou sans neutre, un filtre FIR est associé à chaque phase et éventuellement au neutre. Cependant, si l'on associe un filtre IIR également à chaque phase, la puissance de calcul nécessaire redevient importante. Dans le mode de réalisation particulier de la figure 11, le circuit de traitement d'un déclencheur associé à un réseau triphasé avec neutre comporte un échantillonneur 6, un circuit 8 d'élévation au carré et un filtre FIR 9 associés à chaque phase $\varnothing1$, $\varnothing2$, $\varnothing3$ et au neutre N. Un circuit 14 de maximum est connecté à la sortie des filtres FIR 9. Il fournit en sortie des signaux représentatifs du carré de la valeur efficace du courant le plus élevé pris parmi les courants de phase $I\varnothing1$, $I\varnothing2$, $I\varnothing3$ et de neutre IN. Le déclencheur comporte un seul filtre IIR 5, connecté à la sortie du circuit 14 et un circuit de comparaison 7 connecté à la sortie du filtre 5. On obtient ainsi un bon compromis coût/précision.

Si la protection du conducteur de neutre N n'est pas désirée, le filtre FIR 9 associé à ce conducteur peut être omis.

**Revendications**

**1.** Déclencheur électronique connecté à des moyens (2) de mesure du courant circulant dans un réseau électrique polyphasé à protéger et comportant des moyens (6) d'échantillonnage de signaux de courant (I, I∅1, I∅2, I∅3, IN) fournis par les moyens de mesure, des moyens de calcul, connectés aux moyens d'échantillonnage et calculant une grandeur représentative de l'état thermique du réseau, et des moyens (7) de comparaison de ladite grandeur à des seuils de déclenchement prédéterminés, les moyens de calcul comportant des premiers moyens de filtrage (9), du type filtre à réponse impulsionnelle finie (FIR), recevant les échantillons de signaux de courant et fournissant des signaux représentatifs de la valeur efficace du courant, déclencheur **caractérisé en ce que** les moyens de calcul comportent un premier filtre à réponse impulsionnelle finie (9) associé à chaque phase (∅1, ∅2, ∅3) du réseau, un circuit (14) de maximum, connecté à la sortie des premiers filtres, et un second filtre (5) du type à réponse impulsionnelle infinie (IIR), unique, ayant une entrée connectée à la sortie du circuit (14) de maximum et une sortie connectée aux moyens (7) de comparaison.

2.  Déclencheur selon la revendication 1, **caractérisé en ce que** les moyens de calcul comportent un premier filtre à réponse impulsionnelle finie (9) associé à un conducteur de neutre (N) du réseau et connecté au circuit (14) de maximum.

3.  Déclencheur selon l'une des revendications 1 et 2, **caractérisé en ce que** les moyens d'échantillonnage (6) ajoutent une période de décalage (td) entre deux échantillons successifs après un premier nombre prédéterminé d'échantillons de courant.

4.  Déclencheur selon l'une quelconque des revendications 1 à 3, **caractérisé en ce que** les premiers moyens de filtrage (9) calculent périodiquement (Te1) une nouvelle valeur efficace ($\mathrm{Ieff}^2\mathrm{i}$) du courant après un premier nombre prédéterminé d'échantillons de courant, le calcul étant réalisé à partir d'un second nombre d'échantillons égal au double du premier nombre.

5.  Déclencheur selon la revendication 4, **caractérisé en ce que** le second filtre (5) calcule une nouvelle valeur (θi) de la grandeur thermique (θ) à partir de chaque nouvelle valeur efficace du courant ($\mathrm{Ieff}^2\mathrm{i}$) fournie par les premiers moyens de filtrage (9).

6.  Déclencheur selon l'une des revendications 4 et 5, **caractérisé en ce que** le premier nombre prédéterminé d'échantillons de courant est 9.

7.  Déclencheur selon l'une quelconque des revendications 1 à 6, **caractérisé en ce que** les moyens (6) d'échantillonnage fonctionnent à une fréquence d'échantillonnage de l'ordre de 900 Hz.

8.  Déclencheur selon la revendication 3, **caractérisé en ce que** la période de décalage (td) est de l'ordre de quelques millisecondes.

**Claims**

1.  An electronic trip device connected to measuring means (2) for measuring the current flowing in a multiphase electrical power system to be protected and comprising sampling means (6) for sampling current signals (I, I∅1, I∅2, I∅3, IN) supplied by the measuring means, calculating means connected to the sampling means and calculating a quantity representative of the thermal state of the power system, and means (7) for comparing said quantity to preset tripping thresholds, the calculating means comprising first filtering means (9), of the finite impulse response (FIR) filter type, receiving the current signal samples and supplying signals representative of the rms value of the current, trip device **characterized in that** the calculating means comprise a first finite impulse response filter (9) associated to each phase (∅1, ∅2, ∅3) of the power system, a maximum circuit (14) connected to the output of the first filters, and a single second filter (5) of the infinite impulse response (IIR) type, having an input connected to the output of the maximum circuit (14) and an output connected to the means (7) for comparing.

2.  Trip device according to claim 1, **characterized in that** the calculating means comprise a first finite impulse filter (9) associated to a neutral conductor (N) of the power system and connected to the maximum circuit (14).

3.  Trip device according to one of the claims 1 and 2, **characterized in that** the sampling means (6) add a time delay period (td) between two successive samples after a first preset number of current samples.

4.  Trip device according to any one of the claims 1 to 3, **characterized in that** the first filtering means (9) periodically calculate (Te1) a new rms value (Irms$^2$i) of the current after a first preset number of current samples, calculation being performed from a second number of samples equal to twice the first number.

5. Trip device according to claim 4, **characterized in that** the second filter (5) calculates a new value (θi) of the thermal quantity (θ) from each new rms value (Irms$^2$i) of the current supplied by the first filtering means (9).

6. Trip device according to one of the claims 4 and 5, **characterized in that** the first preset number of current samples is 9.

7. Trip device according to any one of the claims 1 to 6, **characterized in that** the sampling means (6) operate at a sampling frequency of about 900 Hz.

8. Trip device according to claim 3, **characterized in that** the time delay period (td) is about a few milliseconds.


**Patentansprüche**

1. Elektronischer Auslöser, der an Meßmittel (2) zur Messung des Stroms in einem zu schützenden, mehrphasigen Leitungsnetz angeschlossen ist und Abtastmittel (6) zur Abtastung von, durch die Meßmittel gelieferten Stromsignalen (I, I∅1, I∅2, I∅3, IN), an die Abtastmittel angeschlossene Rechenmittel, die eine den thermischen Zustand des Netzes abbildende Größe berechnen, sowie Vergleichsmittel (7) zum Vergleich der genannten Größe mit festgelegten Auslöseschwellwerten umfaßt, wobei die Rechenmittel als Filter mit endlicher Impulsantwort (FIR) ausgebildete erste Filtermittel (9) umfassen, die mit Stromsignal-Abtastwerten beaufschlagt werden und den Effektivwert des Stroms abbildende Signale liefern, **dadurch gekennzeichnet, daß** die Rechenmittel ein erstes, jeder Phase (∅1, ∅2, ∅3) des Netzes zugeordnetes Filter mit endlicher Impulsantwort (9), eine an den Ausgang der ersten Filter angeschlossene Maximumschaltung (14) sowie ein einfach vorhandenes, als Filter mit unendlicher Impulsantwort (IIR) ausgebildetes zweites Filter (5) mit einem an den Ausgang der Maximumschaltung (14) angeschlossenen Eingang sowie einem an die Vergleichsmittel (7) angeschlossenen Ausgang umfassen.

2. Auslöser nach Anspruch 1, **dadurch gekennzeichnet, daß** die Rechenmittel ein erstes Filter mit endlicher Impulsantwort (9) umfassen, das einem Neutralleiter (N) zugeordnet und an die Maximumschaltung (14) angeschlossen ist.

3. Auslöser nach einem der Ansprüche 1 und 2, **dadurch gekennzeichnet, daß** die Abtastmittel (6) ein Shiftintervall (td) zwischen zwei aufeinanderfolgende Abtastungen, im Anschluß an eine erste festgelegte Anzahl von Stromabtastwerten einfügen.

4. Auslöser nach irgendeinem der Ansprüche 1 bis 3, **dadurch gekennzeichnet, daß** die ersten Filtermittel (9) nach Erfassung einer festgelegten ersten Anzahl von Stromabtastwerten periodisch (Te1) einen neuen Effektivwert des Stroms (Ieff$^2$i) berechnen, wobei die Berechnung mit Hilfe einer zweiten Anzahl von Abtastwerten erfolgt, die genauso groß oder doppelt so groß wie die erste Anzahl sein kann.

5. Auslöser nach Anspruch 4, **dadurch gekennzeichnet, daß** das zweite Filter (5) aus jedem neuen, von den ersten Filtermitteln (9) gelieferten Effektivwert (Ieff$^2$i) des Stroms einen neuen Wert (θi) der thermischen Größe (θ) errechnet.

6. Auslöser nach einem der Ansprüche 4 und 5, **dadurch gekennzeichnet, daß** die festgelegte erste Anzahl von Stromabtastwerten 9 beträgt.

7. Auslöser nach irgendeinem der Ansprüche 1 bis 6, **dadurch gekennzeichnet, daß** die Abtastmittel (6) mit einer Abtastfrequenz von etwa 900 Hz arbeiten.

8. Auslöser nach Anspruch 3, **dadurch gekennzeichnet, daß** das Shiftintervall (td) etwa einige Millisekunden beträgt.

Fig.1 (Art antérieur)

Fig. 2 (Art antérieur)

Fig. 3 (Art antérieur)

Fig. 4 (Art. antérieur)

Fig. 5 (Art. antérieur)

Fig. 6

Fig. 7

Fig. 8

Fig. 9

Fig. 10

Fig 11